Europäisches Patentamt

European Patent Office

Office européen des brevets

(19)

(11) Numéro de publication: **0 024 378**
**B1**

(12) **FASCICULE DE BREVET EUROPEEN**

(45) Date de publication du fascicule du brevet: **22.02.84**

(51) Int. Cl.³: **H 01 L 31/18, H 01 L 31/02**

(21) Numéro de dépôt: **80401051.0**

(22) Date de dépôt: **11.07.80**

(54) Procédé de réalisation d'une couche contenant du silicium à structure hybride entre les formes amorphe et polycristalline, et pile solaire comprenant une telle couche.

(30) Priorité: **03.08.79 FR 7919972**

(43) Date de publication de la demande:
**04.03.81 Bulletin 81/9**

(45) Mention de la délivrance du brevet:
**22.02.84 Bulletin 84/8**

(84) Etats contractants désignés:
**CH DE GB IT LI NL SE**

(56) Documents cités:
**FR - A - 2 345 810**
**FR - A - 2 394 173**

**RCA REVIEW, vol. 38, no. 2, juillet 1977, Princeton, US D.E. CARLSON "Properties of Amorphous silicon and a-S-, solar cells", pages 211-225**

(73) Titulaire: **THOMSON-CSF**
**173, Boulevard Haussmann**
**F-75379 Paris Cedex 08 (FR)**

(72) Inventeur: **Kaplan, Daniel**
**"THOMSON-CSF" SCPI 173, Bld Haussmann**
**F-75360 Paris Cedex 08 (FR)**
Inventeur: **Sol, Nicole**
**"THOMSON-CSF" SCPI 173, Bld Haussmann**
**F-75360 Paris Cedex 08 (FR)**
Inventeur: **Landouar, Pierre**
**"THOMSON-CSF" SCPI 173, Bld Haussmann**
**F-75360 Paris Cedex 08 (FR)**

(74) Mandataire: **Lepercque, Jean et al,**
**THOMSON-CSF SCPI 173, Bld Haussmann**
**F-75379 Paris Cedex 08 (FR)**

Courier Press, Leamington Spa, England.

## Procédé de réalisation d'une couche contenant du silicium à structure hybride entre les formes amorphe et polycristalline, et pile solaire comprenant une telle couche

La présente invention concerne un procédé de fabrication de dispositifs électroniques comportant une couche de silicium ou d'un de ses alliages, notamment de cellules photovoltaïques utilisables pour la conversion d'un rayonnement photonique en énergie électrique.

Les cellules photovoltaïques comprennent généralement une structure multicouche, par exemple une jonction p-n ou un contact métal-semiconducteur. On utilise très généralement comme matériau le silicium. Sous sa forme monocristalline ou polycristalline à grains macroscopiques de dimensions supérieures $10^{-5}$ cm, le silicium absorbe peu la lumière, si bien que l'épaisseur minimale de la couche à déposer pour obtenir un rendement approprié est de l'ordre de plusieurs dizaines de microns. Pour réduire le coût des cellules, il est souhaitable d'utiliser des couches les plus minces possible, de l'ordre du micron. Pour cela, on peut utiliser le silicium sous forme amorphe, dont l'absorption optique est nettement supérieure à celle du silicium cristallin. Cependant, le silicium amorphe, obtenu par exemple par décomposition du silane à basse température, a en général des caractéristiques électriques moins bonnes que le silicium cristallin. Par exemple, la mobilité des électrons est de l'ordre de 0,1 $cm^{-2}V^{-1}s^{-1}$, à comparer avec celle du silicium cristallin que peut être de l'ordre de $10^{-3}$ $cm^{-2}V^{-1}s^{-1}$.

Il a été proposé, dans une demande de brevet français no 77.17 245 déposée par la demanderesse, et publié sous le no 2 394 173, un procédé de fabrication de dispositifs comportant une couche de silicium amorphe permettant d'améliorer les propriétés électriques de la couche. Ce procédé consiste à déposer la couche de silicium amorphe par évaporation ou pulvérisation sous vide ou à pression réduite à basse température, puis à effectuer un traitement thermique de la couche déposée dans un plasma d'hydrogène ou de l'un de ses isotopes toujours à une température assez basse pour que le silicium ne cristallise pas. Cette technique d'hydrogénation, appliquée à du silicium amorphe, permet de contrôler la proportion d'hydrogène contenue dans le matériau, ce qui n'est pas aisé dans le cas de la décomposition du silane dans une décharge luminescente. Les avantages recueillis résident principalement dans la flexibilité du mode de préparation, mais les meilleures caractéristiques électriques obtenues restent similaires. D'autre part, dans le cas où l'on veut obtenir une couche de silicium dopé, la technique de dépôt utilisée ne permet pas une introduction aisée du dopant.

Il a été constaté qu'en utilisant une technique de dépôt par décomposition thermique à une température élevée, c'est-à-dire proche de la température de cristallisation du matériau déposé (silicium pur ou dopé), on obtient, après hydrogénation, des résultats très améliorés par rapport aux résultats des procédés connus. A cette température, la couche a une structure hybride entre la forme amorphe et une forme polycristalline à grains très fins. Après traitement dans un plasma d'hydrogène, les valeurs de conductivité obtenues sont plus proches des valeurs correspondantes pour des monocristaux et les valeurs d'absorption optique sont pratiquement aussi élevées que celles obtenues par le procédé antérieur, c'est-à-dire celles des couches amorphes.

L'invention a donc pour objet, conformément en particulier à la revendication 1, la réalisation d'une couche contenant du silicium, à structure hybride entre les formes amorphe et polycristalline, par un procédé caractérisé en ce qu'il comporte une première étape de dépôt par décomposition chimique d'un mélange gazeux comprenant du silane, dépôt effectué à une température comprise entre $T - 50°C$ et $T + 50°C$, T étant la température de cristallisation de la couche, et une deuxième étape de traitement thermique de la couche déposée dans l'atmosphère d'un plasma contenant de l'hydrogène ou l'un de ses isotopes, à une température inférieure à la température de cristallisation de la couche.

En raison de la conductivité et de l'absorption optique élevées des couches obtenues par un tel procédé, celui-ci est particulièrement intéressant pour la réalisation de dispositifs de conversion de l'énergie optique en énergie électrique, notamment une pile solaire selon les revendications 9 à 12.

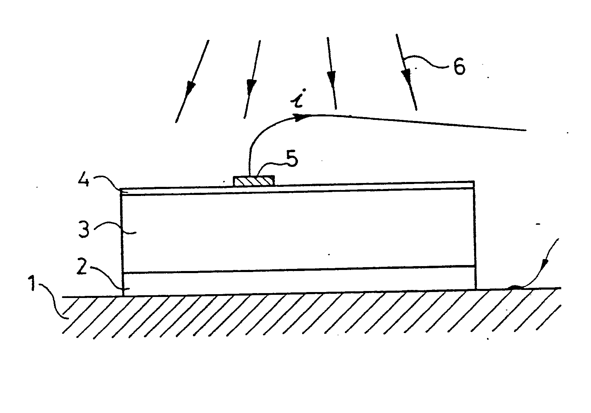

L'invention sera mieux comprise et d'autres caractéristiques apparaîtront au moyen de la description ci-après et du dessin qui l'accompagne et qui comprend une figure unique représentant un mode de réalisation d'une pile solaire dans lequel est mis en oeuvre le procédé de l'invention.

Le procédé objet de l'invention vise à l'obtention d'une couche de silicium ou de l'un de ses alliages, pur ou dopé dans des proportions prédéterminées, sur un substrat de nature quelconque. Il comprend deux étapes successives:

### lère étape

Il s'agit du dépôt proprement dit du matériau choisi sur le substrat. Dans le cas du silicium dopé, pour obtenir une couche de type n, le matériau dopant peut être par exemple de l'arsenic ou du phosphore et pour obtenir une couche de type p, le matériau dopant peut être par exemple du bore ou du gallium. Le dépôt s'effectue par décomposition chimique en phase vapeur d'un mélange gazeux comprenant du silane et, le cas échéant, un autre gaz fournissant le dopant, par exemple l'arsine pour l'arsenic, et le diborane pour le bore, dans des proportions précises suivant le degré de dopage désiré, qui peut varier typiquement de $10^{-6}$ à $10^{-3}$ molécules de gaz dopant pour 1 molécule de silane, le maximum correspondant à une couche dite n+ ou p+. Le mélange est dilué dans un gaz tel que l'hydrogène ou l'argon par exemple. La décomposition s'effectue à une température choisie dans une gamme proche de la température de cristallisation du matériau. Le substrat sur lequel est déposée la couche dépend de la structure du dispositif électronique envisagé. Le procédé peut permettre par exemple le dépôt d'une couche mince de type n (l'épaisseur peut être de l'ordre du micron) sur une couche épaisse de type p ou du type n+, obtenue par une technique quelconque.

La température de cristallisation peut être définie par la technique connue de diffraction des rayons X par une couche du matériau. Il est connu en effet qu'une couche monocristalline produit un réseau de diffraction régulier, en raison de la structure de type cubique diamant des cristaux. Avec une couche amorphe, ou ne distingue plus que des halos caractéristiques de l'arrangement tétrahédrique des atomes. Lorsqu'on observe la figure de diffraction obtenue pour des dépôts effectués à des températures croissantes, pour des basses températures, la couche étant amorphe, la figure est formée des halos mentionnés ci-dessus. A partir d'une certaine température T, on constate une modification progressive des halos, dans le sens d'un rétrécissement. Ils tendent á se transformer en raies de diffractions étroites caractéristiques du cristal. Cette modification est facilement observable et permet de définir la température T avec précision. Dans des conditions de dépôt données définies notamment par la structure du réacteur dans lequel s'effectue la décomposition et par la composition du mélange gazeux, la température de cristallisation est égale à la température T définie ci-dessus. Pour du silicium pur, elle vaut environ 650°C. On constate que, des températures allant jusqu'à 50°C de part et d'autre de T, le coefficient d'absorption optique varie peu et est donc voisin de sa valeur pour une couche amorphe déposée à basse température. Par ailleurs, la couche obtenue est très homogène; la répartition des défauts et notamment des liaisons chimiques non établies est continue.

*2ème étape*

Il s'agit du traitement de la couche déposée dans un plasma d'hydrogène ou de l'un de ses isotopes ou d'un mélange de ces corps. Le traitement, effectué à une température inférieure à la température de cristallisation (de l'ordre de 350°C à 450°C), a pour but d'introduire des atomes d'hydrogène dans des liaisons chimiques non établies du fait de la nature quasi amorphe de la couche déposée afin de les passiver. Après un traitement dont la durée est par exemple d'un quart d'heure, on obtient, pour un échantillon dopé, une augmentation de la conductivité mesurée, de telle sorte qu'on aboutit à une valeur de même ordre de grandeur que celle d'un monocristal de même composition. Les propriétés absorbantes, elles, sont conservées dans ce traitement.

A titre d'exemple, le procédé de l'invention a été mis en oeuvre en déposant une couche de 0,5 $\mu$m d'épaisseur à partir d'un mélange gazeux constitué de silane et d'arsine à raison de $10^4$ molécules de silane pour 1 molécule d'arsine, mélange dilué dans l'hydrogène et porté à une température de 600°C pendant environ 1 heure, durée nécessaire pour que le dépôt soit complet. La conductivité mesurée alors était de $7.10^{-8}$ $\Omega^{-1}$ cm$^{-1}$. On a ensuite effectué un traitement d'un quart d'heure dans un plasma d'hydrogène à 400°C. La conductivité est alors passée à 70 $\Omega^{-1}$ cm$^{-1}$, soit un gain d'un facteur $10^9$. Cette forte conductivité, proche des valeurs maximales obtenues pour un monocristal, indique que la mobilité des électrons est elle-même voisine de celle d'un cristal. L'absorption mesurée pour une longueur d'onde de 0.6 $\mu$m est de $2.10^4$ à $4.10^4$ cm$^{-1}$.

Pour l'application de telles couches à la conversion de l'énergie solaire, le rendement de conversion est limité par la résistance électrique de la couche. Une couche peu résistive telle que celle obtenue par le procédé de l'invention permet d'augmenter le rendement par rapport aux rendements obtenus pour une couche à silicium amorphe.

A titre d'exemple, on décrira l'application dans le cas d'une jonction métal-silicium. Une pile solaire est représentée sur la figure unique. Elle est formée de couches superposées: un substrat métallique 1, une couche 2 en silicium dopé n+ (proportion d'As/Si = $10^{-3}$), une couche mince 3, d'épaisseur 0,5 à 1 $\mu$m de silicium dopé n (proportion d'As/Si = $10^{-6}$) et une couche métallique 4, par exemple en platine, très mince (50 Å) de façon à être transparente aux rayonnements solaires 6 auxquels la couche 3 doit être exposée. Un plot métallique 5 situé sur la couche 4 permet de recueillir le courant i obtenu par effet photovoltaïque dans la couche 3. Les photons lumineux traversent la couche métallique 3 pratiquement sans être absorbés. Ils sont par contre absorbés par la couche de silicium 2 qui, comme il a été rappelé, peut avoir un coefficient d'absorption d'environ $2 \cdot 10^4$ cm$^{-1}$, si bien que, pour une épaisseur de couche de 1 $\mu$m la portion de rayonnement absorbée est égale à $1 - e^{-2}$ 1, e étant la base des logarithmes naturels (e = 2.718). Les photons absorbés génèrent des paires électrons-trous qui sont dissociées dans la couche 3 libérant ainsi des électrons pouvant circuler dans la couche 4. On obtient ainsi un courant électrique i dans la couche métallique 4, lorsque celle-ci est reliée à un circuit extérieur de charge. On peut obtenir également un courant en réalisant des jonctions entre deux couches semiconductrices, notamment des jonctions p-n, au moins l'une de ces couches étant en silicium ou l'un de ses alliages étant réalisée par le procédé de l'invention.

**Revendications**

1. Procédé de réalisation d'une couche de silicium ou de l'un de ses alliages, pur ou dopé dans es proportions prédéterminées, à structure hybride entre la forme amorphe et une forme polycristalline à grains très fins, caractérisé en ce qu'il comporte une première étape de dépôt de ladite couche par décomposition chimique d'un mélange gazeux comprenant du silane, dépôt effectué à une température comprise entre T −50°C et T +50°C, T étant la température de cristallisation de la couche, définie par les conditions de dépôt et une deuxième étape de traitement thermique de la couche déposée dans l'atmosphère d'un plasma contenant de l'hydrogène ou l'un de ses isotopes, à une température inférieure à ladite température de cristallisation de la couche.

2. Procédé selon la revendication 1, caractérisé en ce que la couche est formée de silicium pur.

3. Procédé selon la revendication 1, caractérisé en ce que la couche est formée de silicium dopé de type n.

4. Procédé selon la revendication 3, caractérisé en ce que le mélange gazeux comprend du silane et de l'arsine dans des proportions prédéterminées.

5. Procédé selon la revendication 4, caractérisé en ce que la décomposition est effectuée à 600°C, les proportions étant de $10^4$ molécules de silane pour 1 molécule d'arsine.

6. Procédé selon la revendication 1, caractérisé en ce que la couche est formée de silicium dopé de type p.

7. Procédé selon la revendication 6, caractérisé en ce que le mélange gazeux comprend du silane et du bore dans des proportions prédéterminées.

8. Procédé selon l'une quelconque des revendications 1 à 7, caractérisé en ce que le mélange gazeux est dilué dans l'hydrogène.

9. Pile solaire comprenant une jonction comportant une première couche (3) contenant du silicium exposée aux rayonnements solaires, caractérisée en ce que la couche (3) est réalisée par le procédé selon l'une quelconque des revendications précédentes.

10. Pile solaire selon la revendication 9, caractérisé en ce que la première couche (3) est une couche mince de type n déposée sur une couche sous-jacente (2).

11. Pile solaire selon la revendication 9, caractérisée en ce que la première couche (3) est une couche mince de type n déposée sur un substrat (1) et recouverte d'une couche métallique (4) transparente aux rayonnements solaires.

12. Pile solaire selon la revendication 11, caractérisée en ce que la couche métallique (4) est en platine.

**Patentansprüche**

1. Verfahren zum Herstellen einer Schicht aus Silizium oder aus einer Siliziumlegierung in reinem Zustand oder in vorbestimmten Anteilen dotiert, mit einer hybriden Struktur zwischen der amorphen Form und einer polykristallinen, sehr feinkörnigen Form, dadurch gekennzeichnet, daß in einer ersten Stufe die Schicht durch chemische Zersetzung eines Silan enthaltenden Gasgemischs abgeschieden wird, wobei die Abscheidung bei einer Temperatur zwischen T −50°C und T +50°C erzeugt wird, wenn T die Kristallisationstemperatur der Schicht ist, die von den Abscheidungsbedingungen festgelegt wird, und daß in einer zweiten Stufe die abgeschiedene Schicht in der Atmosphäre eines Plasmas einer Wärmebehandlung unterzogen wird, die Wasserstoff oder eines seiner Isotopen enthält, wobei dies Wärmebehandlung bei einer Temperatur durchgeführt wird, die unter der Kristallisierungstemperatur der Schicht liegt.

2. Verfahren nach Anspruch 1, dadurch gekennzeichnet, daß die Schicht aus reinem Silizium gebildet ist.

3. Verfahren nach Anspruch 1, dadurch gekennzeichnet, daß die Schicht aus n-dotiertem Silizium gebildet wird.

4. Verfahren nach Anspruch 3, dadurch gekennzeichnet, daß das Gasgemisch Silan und Arsen in vorbestimmten Anteilen enthält.

5. Verfahren nach Anspruch 4, dadurch gekennzeichnet, daß die Zersetzung bei 600°C durchgeführt wird und daß die Anteile $10^4$ Silanmoleküle für jeweils ein Arsenmolekül betragen.

6. Verfahren nach Anspruch 1, dadurch gekennzeichnet, daß die Schicht aus p-dotiertem Silizium hergestellt wird.

7. Verfahren nach Anspruch 6, dadurch gekennzeichnet, daß das Gasgemisch Silan und Bor in vorbestimmten Anteilen enthält.

8. Verfahren nach einem der Ansprüche 1 bis 7, dadurch gekennzeichnet, daß das Gasgemisch in Wasserstoff verdünnt ist.

9. Sonnenzelle mit einem Übergang, der eine Silizium enthaltende erste Schicht (3) enthält, die Sonnenstrahlen ausgesetzt ist, dadurch gekennzeichnet, daß die Schicht (3) nach dem Verfahren gemäß einem der vorhergehenden Ansprüche hergestellt ist.

10. Sonnenzelle nach Anspruch 9, dadurch gekennzeichnet, daß die erste Schicht (3) eine dünne Schicht des n-Typs ist, die auf eine darunterliegende Schicht (2) aufgebracht ist.

11. Sonnenzelle nach Anspruch 9, dadurch gekennzeichnet, daß die erste Schicht (3) eine dünne Schicht vom n-Typ ist, die auf ein Substrat (1) aufgebracht und von einer dünnen Metallschicht (4) bedeckt ist, die für Sonnenstrahlen durchlässig ist.

12. Sonnenzelle nach Anspruch 11, dadurch gekennzeichnet, daß die dünne Metallschicht (4) aus Platin besteht.

## Claims

1. A method for producing a layer of silicon or of a silicon alloy, either pure or doped with predetermined proportions, said layer having a hybride structure between the amorphous and the polycrystalline, very fine grained form, characterized in that in a first step the layer is deposited by chemical decomposition of a gas mixture containing silane, the deposition being effected at a temperature between T −50°C and T +50°C, wherein T is crystallization temperature of the layer defined by the deposition conditions, and that in a second stage the deposited layer is subjected to a heat treatment in a plasma atmosphere containing hydrogen or one of its isotopes, the heat treatment being carried out at a temperature below the crystallization temperature of the layer.

2. Method according to claim 1, characterized in that the layer is formed of pure silicon.

3. Method according to claim 1, characterized in that the layer is formed of n-doped silicon.

4. Method according to claim 3, characterized in that the gas mixture contains silane and arsenic in predetermined proportions.

5. Method according to claim 4, characterized in that the decomposition is carried out at 600°C and that the proportions amount to $10^4$ silane molecules per one arsenic molecule.

6. Method according to claim 1, characterized in that the layer is formed of p-doped silicon.

7. Method according to claim 6, characterized in that the gas mixture contains silane and boron in predetermined proportions.

8. Method according to any one of claims 1 to 7, characterized in that the gas mixture is diluted in hydrogen.

9. Solar cell having a junction containing a first layer (3) exposed to sun rays, said layer comprising silicon, characterized in that the layer (3) is produced according to any one of the preceding claims.

10. Solar cell according to claim 9, characterized in that the first layer (3) is a thin layer of n-type, deposited on a subjacent layer (2).

11. Solar cell according to claim 9, characterized in that the first layer (3) is a thin layer of n-type deposited on a substrate (1) and covered by a thin metal layer (4) transparent to sun rays.

12. Solar cell according to claim 11, characterized in that the thin metal layer (4) comprises platinum.